# EUROPÄISCHE PATENTSCHRIFT

(11) **EP 3 207 774 B1**
(45) Veröffentlichungstag und Bekanntmachung des Hinweises auf die Patenterteilung: **04.07.2018**
(21) Anmeldenummer: 15756896.5
(22) Anmeldetag: 27.08.2015
(51) Int. Cl.: H05K 3/34, H05K 1/02, H01G 4/232, H01G 4/30, H01L 23/495

(54) **ELEKTRONISCHES BAUELEMENT MIT EINEM ANSCHLUSSELEMENT**
ELECTRONIC COMPONENT HAVING A CONNECTION ELEMENT
COMPOSANT ÉLECTRONIQUE POURVU D'UN ÉLÉMENT DE CONNEXION

(30) Priorität: 14.10.2014 DE 102014220802
(43) Veröffentlichungstag der Anmeldung: 23.08.2017
(73) Patentinhaber: Robert Bosch GmbH, 70442 Stuttgart (DE)
(72) Erfinder: PEUSER, Thomas, 71636 Ludwigsburg (DE)
(86) Internationale Anmeldenummer: PCT/EP2015/069613
(87) Internationale Veröffentlichungsnummer: WO 2016/058741

(56) Entgegenhaltungen:
- EP-A1- 2 131 374
- DE-A1- 2 731 998
- JP-A- H01 289 151
- US-A- 4 158 218
- US-A1- 2002 009 610
- US-A1- 2011 075 386

## Beschreibung

### Stand der Technik

Die Erfindung betrifft ein elektronisches Bauelement. Das elektronische Bauelement weist ein elektrisches Bauteil mit zwei elektrischen Anschlüssen auf, welche jeweils an zueinander gegenüberliegenden Flächen, insbesondere Stirnflächen des Bauteils ausgebildet sind. Das Bauelement weist für jeden Anschluss wenigstens ein elektrisch leitfähiges Anschlusselement auf. Das Anschlusselement weist einen Befestigungsfuß zum Verbinden mit einem Schaltungsträger auf, wobei das Anschlusselement mit dem elektrischen Anschluss des Bauelements stoffschlüssig verbunden und ausgebildet ist, das Bauelement zu tragen.

Elektronische Bauelemente mit elektrischen Anschlüssen aus dem Stand der Technik sind beispielsweise aus der EP 2 131 374 A1, der JP H01 289151 A, der US 4 158 218 A, der DE 27 31 998 A1, der US 2011/075386 A1 und der US 2002/009610 A1 bekannt.

### Offenbarung der Erfindung

Erfindungsgemäß weist das Anschlusselement wenigstens auf einem Abschnitt des Anschlusselements wenigstens zwei Metallschichten auf, wobei die Metallschichten jeweils aus zueinander verschiedenen Metallen gebildet sind. Die Metallschichten sind miteinander stoffschlüssig verbunden, wobei eine Basisschicht der Metallschichten mit dem Anschluss verbunden ist, und im Bereich des Befestigungsfußes zum elektrischen Verbinden, insbesondere stoffschlüssigen Verbinden, insbesondere Lötverbinden, Sinterverbinden, oder elektrisch leitfähigen Klebverbinden mit einem Schaltungsträger ausgebildet ist. Bevorzugt ist die wenigstens eine weitere Metallschicht der Metallschichten zu der Basisschicht thermisch oder zusätzlich elektrisch parallel geschaltet. Bevorzugt weist eine weitere Metallschicht, insbesondere die mit der Basisschicht stoffschlüssig verbundene Metallschicht, eine größere thermische Leitfähigkeit auf als die Basisschicht. So kann vorteilhaft von dem elektronischen Bauelement erzeugte Verlustwärme über das Anschlusselement mit verbesserter Wärmeleitfähigkeit abgeführt werden, im Vergleich zu einem Anschlusselement, welches nur aus der Basisschicht gebildet ist. Weiter vorteilhaft kann so über dasselbe Bauelement eine größere Verlustleistung erzeugt werden, verglichen mit einem Bauelement, welches ein Anschlusselement, bestehend aus der Basisschicht, aufweist.

Bevorzugt sind die Metallschichten mindestens von der Verbindung zum Anschluss des Bauelements, bis hin zum Befestigungsfuß, insbesondere ununterbrochen, stoffschlüssig miteinander verbunden. Die stoffschlüssige Verbindung kann beispielsweise durch Plattieren, insbesondere Walzplattieren, Elektroplattieren, oder kathodisches Aufstäuben, oder durch Hartlöten oder durch Laserschweißen erzeugt werden. So kann das Anschlusselement, und so auch das Bauelement, vorteilhaft aufwandsgünstig bereitgestellt werden. So kann beispielsweise zum Erzeugen des Anschlusselements, insbesondere eines Anschlusswinkelelements, ein Blech umfassend die zwei Metallschichten, nämlich die zuvor genannte Basisschicht und die weitere Metallschicht, welche eine größere Wärmeleitfähigkeit aufweist als die Basisschicht, dadurch erzeugt werden, dass die Metallschichten mittels Plattieren, insbesondere Walzplattieren miteinander verbunden werden. Das so doppelschichtig ausgebildete Blech kann dann mittels eines Stanz- und/oder Umformprozesses zu dem abgewinkelten Anschlusselement geformt werden.

Vorteilhaft braucht so zum Erzeugen des Bauelements mit einem Anschlusselement, welches das elektronische Bauteil aufweist, ein Herstellungsprozess nicht grundsätzlich verändert werden.
Vorteilhaft kann nämlich ein Anschlusselement, das nur aus einer Metallschicht gebildet ist, durch ein Anschlusselement umfassend wenigstens zwei Metallschichten ersetzt werden. Dadurch kann ein thermisch verbessertes Bauelement gebildet sein.
Bevorzugt weist das Anschlusselement dazu wenigstens zwei, nur zwei, oder drei Metallschichten auf.

In einer bevorzugten Ausführungsform ist die Basisschicht durch eine Legierung, umfassend Eisen, gebildet, und die weitere Schicht mit der größeren thermischen Leitfähigkeit als die Basisschicht, durch eine Kupferschicht gebildet.

Dadurch kann das Bauelement vorteilhaft aufwandsgünstig bereitgestellt werden. Vorteilhaft braucht im Falle von Kupfer als weitere Schicht eine Schichtdicke der weiteren Metallschicht nur einen Teil der Schichtdicke der Basisschicht betragen, um so eine deutliche Verbesserung der Wärmeleitfähigkeit des Anschlusselements zu erzeugen.

Bevorzugt beträgt eine Schichtdicke der mit der Basisschicht unmittelbar verbundenen weiteren Metallschicht zwischen einem Zehntel und der Hälfte der Schichtdicke der Basisschicht. Beispielsweise beträgt eine Schichtdicke der weiteren Schicht, als Kupferschicht, ein Drittel der Schichtdicke der Basisschicht, insbesondere einer Eisenlegierungs-Schicht. Die Basisschicht ist beispielsweise durch eine Legierung, umfassend 30 bis 45 Prozent Nickel oder zusätzlich wenigstens einen weiteren Legierungsbestandteil, und als übrigen Bestandteil oder Hauptbestandteil Eisen gebildet. Vorteilhaft weist die Basisschicht aus einer solchen Legierung eine hinreichend gute elektrische Leitfähigkeit und einen geringen thermische Ausdehnungskoeffizienten auf. Der thermische Ausdehnungskoeffizient einer solchen Basisschicht beträgt bevorzugt weniger als 10 ppm pro Kelvin.

In einer bevorzugten Ausführungsform ist das Bauelement ein Kondensator, insbesondere ein keramischer Kondensator oder ein Folienkondensator, beispielsweise ein SMD-Folienkondensator (SMD = Surface-Mounted-Device). So kann vorteilhaft ein Leistungskondensator als Bauelement gebildet sein, welcher im Vergleich zu demselben Leistungskondensator mit einem Anschlusselement, gebildet aus nur einer Basisschicht, eine größere Wärmeleistung erzeugen und auch abführen kann.

Bevorzugt weist das elektronische Bauelement ein elektrisches Bauteil, insbesondere einen Kondensator, eine Diode oder einen Widerstand mit einer Quaderform oder Zylinderform auf, wobei Stirnflächen des Bauteils jeweils durch einen elektrischen Anschluss gebildet sind. Dadurch kann das Bauelement vorteilhaft platzsparend mit dem Anschlusselement mit einem Schaltungsträger verlötet werden.

In einer bevorzugten Ausführungsform ist das Bauteil ein Widerstand oder eine Diode, insbesondere eine Halbleiterdiode, bevorzugt Leistungs-Halbleiterdiode. Der Widerstand und/oder die Diode sind jeweils ausgebildet, mit einem Schaltungsträger verlötet, insbesondere reflow-verlötet, selektivverlötet, oder wellenverlötet zu werden. Dazu kann das Bauelement mit dem Befestigungsfuß auf den Schaltungsträger und auch auf eine elektrisch leitfähige Schicht, insbesondere eine Leiterbahn des Schaltungsträgers, gestellt werden, wobei die elektrisch leitfähige Schicht mit einer Lotpaste bedruckt worden ist. In einem anschließenden Schritt zum Verlöten des Bauelements mit dem Schaltungsträger kann der Schaltungsträger zusammen mit dem Bauelement - beispielsweise in einem Reflow-Lötofen - verlötet werden.

Bevorzugt ist das Bauelement zum Lötverbinden, bevorzugt Reflow-Lötverbinden mit dem Schaltungsträger ausgebildet. Durch die gute thermische Anbindung an den Schaltungsträger ist das Bauelement gut gekühlt. Vorteilhaft braucht das Bauelement, insbesondere der zuvor erwähnte Kondensator, Widerstand oder die Diode, nicht zusätzlich durch einen weiteren Kühlkörper gekühlt werden, und so auch nicht an einen weiteren, gesonderten Kühlkörper, beispielsweise eine Konvektionsrippen aufweisenden Aluminiumkühlkörper, angekoppelt werden, um über das Bauelement größere Leistungen führen zu können und so auch größere Verlustleistungen in Form von Verlustwärme zu erzeugen.

Die weitere Metallschicht, welche mit der Basisschicht stoffschlüssig verbunden ist, ist bevorzugt eine Kupferschicht, eine Aluminiumschicht oder eine Silberschicht. Die Silberschicht weist vorteilhaft eine große Wärmeleitfähigkeit auf, sodass die weitere Metallschicht als Silberschicht, verglichen mit einer Aluminium- oder Kupferschicht, dünner ausgebildet sein kann, um dieselbe Wärmeleistung über das Anschlusselement zum Schaltungsträger hin zu führen.

In einer bevorzugten Ausführungsform des Bauelements ist das Anschlusselement ein Winkelelement, welches zwei aneinander angeformte und sich in einem vorbestimmten Winkel zueinander erstreckende Schenkel aufweist. Ein Schenkel des Anschlusselements bildet dabei einen Befestigungsfuß, wobei der weitere Schenkel einen Anschlussschenkel bildet, welcher mit dem elektrischen Anschluss verbunden, insbesondere lötverbunden mittels eines leitfähigen Klebstoffs elektrisch leitfähig klebeverbunden, oder schweißverbunden ist. Die Schweißverbindung ist beispielsweise mittels Widerstandsschweißen oder Laserschweißen erzeugt. So kann das Bauelement vorteilhaft aufwandsgünstig mit einem Befestigungsfuß versehen sein. Erfindungsgemäß weist das Anschlusselement eine weitere Metallschicht auf, welche aus dem Metall der Basisschicht gebildet ist. Die Metallschicht mit der größeren thermischen Leitfähigkeit im Vergleich zu der Basisschicht ist zwischen der Basisschicht und der weiteren Metallschicht aus dem Metall der Basisschicht - insbesondere nach Art eines Sandwiches - eingeschlossen. Bevorzugt ist die weitere Metallschicht aus dem Metall der Basisschicht mit der weiteren Metallschicht mit der größeren thermischen Leitfähigkeit stoffschlüssig verbunden. Auf diese Weise ist ein stoffschlüssig verbundener Sandwichverbund gebildet, welcher vorteilhaft - beispielsweise mittels Walzplattieren - als Rohblech-Ausgangsmaterial zum Erzeugen des Anschlusselements aufwandsgünstig bereitgestellt werden kann. Das so gebildete Anschlusselement weist vorteilhaft bei Temperaturveränderungen eine kleinere Verkrümmung quer zu seiner flachen Erstreckung auf, insoweit ein Bimetalleffekt, erzeugt durch zueinander verschiedene Wärmeausdehnungskoeffizienten der zueinander verschiedenen Metallschichten, durch die weitere Metallschicht, welche aus dem Metall der Basisschicht gebildet ist, kompensiert werden kann.

Im Folgenden wird die Erfindung anhand von Figuren und weiteren Ausführungsbeispielen beschrieben. Weitere vorteilhafte Ausführungsvarianten ergeben sich aus den in den abhängigen Ansprüchen und in den Figuren beschriebenen Merkmalen.
Figur 1 zeigt ein Ausführungsbeispiel für eine Verbindungsanordnung mit einem quaderförmigen elektronischen Bauelement, welches an zueinander gegenüberliegenden Stirnseiten angeordnete elektrische Anschlüsse aufweist, welche mittels eines doppelschichtig ausgebildeten Anschlusselements mit einem Schaltungsträger lötverbunden sind;
Figur 2 zeigt ein Ausführungsbeispiel für ein elektronisches Bauelement, welches Anschlusselemente mit jeweils drei Metallschichten aufweist.

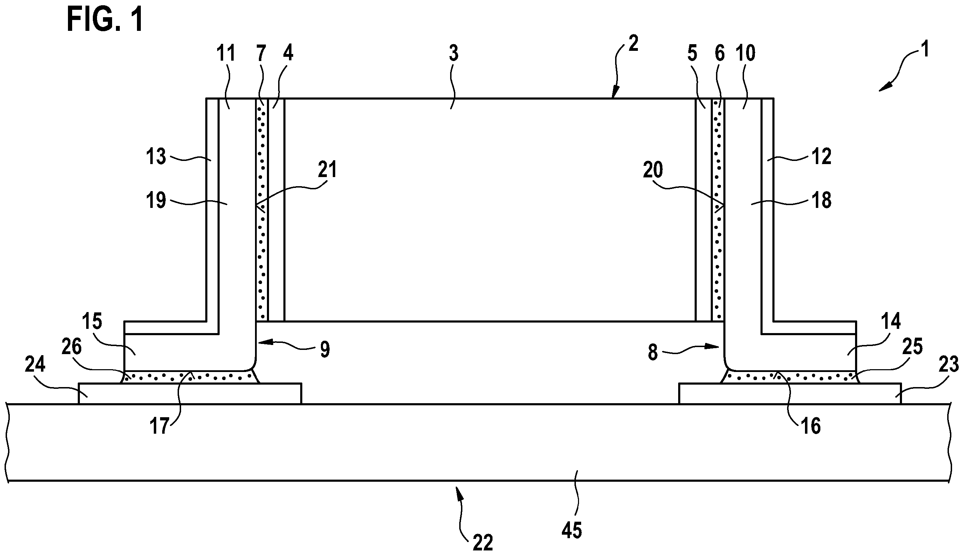

Figur 1 zeigt - schematisch - ein Ausführungsbeispiel für eine Verbindungsanordnung 1. Die Verbindungsanordnung 1 weist ein elektronisches Bauelement 2 auf. Das elektronische Bauelement 2 weist in diesem Ausführungsbeispiel ein elektronisches Bauteil 3, in diesem Ausführungsbeispiel einen Kondensator, insbesondere einen keramisch ausgebildeten Kondensator, auf. Das elektronische Bauteil 3 weist einen elektrischen Anschluss 4 und einen elektrischen Anschluss 5 auf. Die elektrischen Anschlüsse 4 und 5 sind jeweils als elektrisch leitfähige Schicht ausgebildet, welche das elektronische Bauteil 3, in diesem Ausführungsbeispiel den Kondensator, zwischen einander einschließen und welche sich parallel zueinander erstrecken.

Das Bauelement 2 weist auch ein Anschlusselement 8 auf, wobei das Anschlusselement 8 durch ein Winkelelement gebildet ist. Das Anschlusselement 8 weist einen Befestigungsfuß 14 auf, welcher durch einen Schenkel des Anschlusselements 8 gebildet ist, und einen weiteren Schenkel 18, wobei der Anschlussschenkel 18 eine Kontaktfläche 20 aufweist, welche zu dem Anschluss 5 weist, und mittels eines Lotmittels 6 mit dem Anschluss 5 stoffschlüssig lötverbunden ist.

Der Schenkel des Anschlusselements 8, welcher den Befestigungsfuß 14 bildet, erstreckt sich in einen rechten Winkel zu dem Anschlussschenkel 18.

Das Anschlusselement 8 weist in diesem Ausführungsbeispiel zwei Metallschichten auf, nämlich eine Basisschicht 10 und weitere Metallschicht 12, welche jeweils aufeinander liegen und stoffschlüssig miteinander verbunden sind. Die stoffschlüssige Verbindung zwischen der Basisschicht 10 und der weiteren Metallschicht 12 ist in diesem Ausführungsbeispiel mittels Walzplattieren erzeugt.

Die Basisschicht 10 ist in diesem Ausführungsbeispiel aus einer Eisen-Nickel-Legierung gebildet, wobei der Nickelanteil 42 Prozent beträgt. Die weitere Metallschicht 12 ist in diesem Ausführungsbeispiel durch eine Kupferschicht gebildet. Eine Dickenerstreckung der weiteren Metallschicht 12 beträgt in diesem Ausführungsbeispiel einem Drittel der Dickenerstreckung der Basisschicht 10.

Beispielsweise beträgt eine Dickenerstreckung der Basisschicht 10 0,6 Millimeter und eine Dickenerstreckung der weiteren Metallschicht 12, in diesem Ausführungsbeispiel der Kupferschicht, 0,2 Millimeter. Bei einer solchen Schichtanordnung des Anschlusselements 8 kann im Vergleich zu einem Anschlusselement, welches nur die Basisschicht 10 umfasst, 30 Prozent mehr Wärme von dem Bauelement 2 über das Anschlusselement 8 abgeführt werden.

Der Befestigungsfuß 14 ist in diesem Ausführungsbeispiel mittels eines Lotmittels 25 mit einer elektrisch leitfähigen Schicht 23, insbesondere einer Leiterbahn, eines Schaltungsträgers 22, verbunden. Der Schaltungsträger 22 weist in diesem Ausführungsbeispiel eine elektrisch isolierende Schicht 45, insbesondere eine faserverstärkte Epoxidharzschicht oder eine Keramikschicht auf, welche mit der elektrisch leitfähigen Schicht 23 als Bestandteil des Schaltungsträgers 22 verbunden ist. Der Schaltungsträger 22 weist auch eine elektrisch leitfähige Schicht 24, insbesondere eine Leiterbahn auf, welche mittels eines Lotmittels 26 mit dem Besfestigungsfuß 15 eines Anschlusselements 9 verlötet ist, und so mit dem Anschluss 4 des Bauelements 2 elektrisch leitfähig verbunden ist. Das Anschlusselement 9 ist in diesem Ausführungsbeispiel Bestandteil des Bauelements 2, wobei das Anschlusselement 9 wie das Anschlusselement 8 ausgebildet ist. Dazu weist das Anschlusselement 9 einen Anschlussschenkel 19 auf, welcher eine Kontaktfläche 21 aufweist, welche dem elektrischen 4, gebildet durch eine elektrisch leitfähige Schicht zugewandt ist und mittels eines Lotmittels 7 mit dem elektrischen Anschluss 4 des Bauelements 2 verlötet ist.

An dem Anschlussschenkel 19 ist ein weiterer Schenkel, gebildet durch einen Befestigungsfuß 15, angeformt. Der Schenkel, gebildet durch den Befestigungsfuß 15, und der Anschlussschenkel 19, erstrecken sich jeweils in einem rechten Winkel zueinander.

Das Anschlusselement 9 weist eine Metallschicht auf, welche eine Basisschicht 11 bildet. Die Basisschicht 11 entspricht der Basisschicht 10 des Anschlusselements 8. Mit der Basisschicht 11 ist in diesem Ausführungsbeispiel eine mittels Walzplattieren stoffschlüssig verbundene weitere Metallschicht 13, in diesem Ausführungsbeispiel eine Kupferschicht, verbunden. Die weitere Metallschicht 13 weist in diesem Ausführungsbeispiel eine Dickenerstreckung auf, welche ein Drittel einer Dickenerstreckung der Basisschicht 11 beträgt.

Zum Erzeugen der Verbindungsanordnung 1 kann das Bauelement 2 auf den Schaltungsträger 3 gestellt werden, wobei der Schaltungsträger 3, insbesondere die elektrisch leitfähigen Schichten 23 und 24, jeweils mit einer Lotpaste, als Lotmittel 25 beziehungsweise 26 bedruckt sein kann.

Das Bauelement 2 kann dann zum Lötverbinden mit dem Schaltungsträger 22 auf den Schaltungsträger 22 gestellt werden. Dazu kann der Befestigungsfuß 14 des Anschlusselements 8 mit einer Kontaktfläche 16 des Befestigungsfußes 14, welcher in diesem Ausführungsbeispiel eine Standfläche bildet, auf das Lotmittel 25 gesetzt werden und der Befestigungsfuß 15 des Anschlusselements 9, mit einer Kontaktfläche 17, welche eine Standfläche des Anschlusselements 9 bildet, auf das Lotmittel 26 gesetzt werden.

Zum Verlöten des Bauelements 2 mit dem Schaltungsträger 22 kann dann die Verbindungsanordnung 1 in einem Lötofen Reflow-verlötet werden.

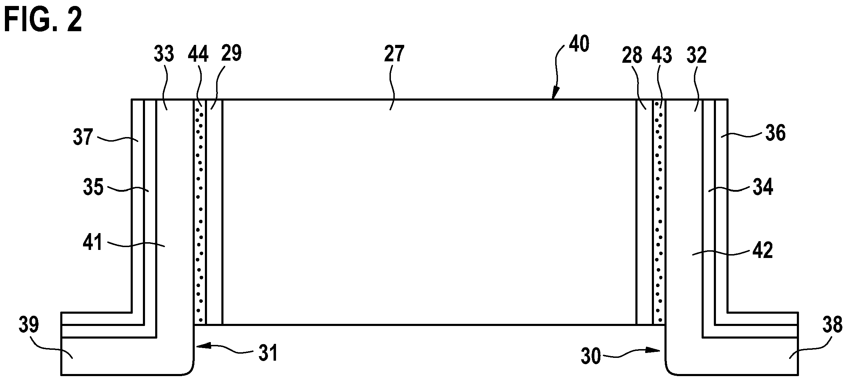

Figur 2 zeigt - schematisch - ein Ausführungsbeispiel für ein Bauelement 40. Das Bauelement 40 weist in diesem Ausführungsbeispiel ein elektrisches Bauteil 27 auf. Das elektrische Bauteil 27 ist beispielsweise durch eine Diode, insbesondere eine Halbleiterdiode, einen Kondensator oder einen Widerstand gebildet.

Das elektrische Bauteil 27 kann in einer anderen Ausführungsform auch als Kondensator, insbesondere als keramischer Kondensator oder als Widerstand, ausgebildet sein. Das elektrische Bauteil 27 weist einen elektrischen Anschluss 28, einen elektrischen Anschluss 29 auf. Der elektrische Anschluss 28 ist mittels eines Lotmittels 43 mit einem Anschlussschenkel 42 eines Anschlusselements 30 verbunden. Das Anschlusselement 30 weist einen an den Anschlussschenkel 42 angeformten Befestigungsfuß 38 als weiteren Schenkel auf. Der Befestigungsfuß 38 und der Anschlussschenkel 42 erstrecken sich in diesem Ausführungsbeispiel in einem rechten Winkel zueinander.

Das Anschlusselement 30 umfasst in diesem Ausführungsbeispiel eine Metallschicht 32 als Basisschicht, welche mit einer weiteren Metallschicht 34, welche eine größere thermische Leitfähigkeit aufweist als die Basisschicht 32, stoffschlüssig verbunden. Die weitere Metallschicht 34 mit der größeren elektrischen Leitfähigkeit als die Basisschicht 32 ist mit einer weiteren Metallschicht 36 stoffschlüssig verbunden, wobei die weitere Metallschicht 36 aus dem Metall der Basisschicht 32 gebildet ist. Auch so kann vorteilhaft ein Bimetalleffekt, welcher aufgrund zueinander verschiedener Wärmeausdehnungskoeffizienten der Basisschicht 32 und der weiteren Metallschicht 34 entstehen kann, kompensiert werden.

Die Basisschicht 32 und die weitere Metallschicht 36 sind in diesem Ausführungsbeispiel aus einer Eisen-Nickel-Legierung gebildet, wobei ein Nickelanteil der Legierung 42 Prozent beträgt. Die weitere Metallschicht 34, welche eine größere thermische Leitfähigkeit aufweist als die Metallschichten 32 und 36, ist in diesem Ausführungsbeispiel durch eine Kupferschicht gebildet. Eine Dickenerstreckung der weiteren Metallschicht 34 beträgt in diesem Ausführungsbeispiel 1/3 der Dickenerstreckung der Basisschicht 32. Eine Dickenerstreckung der weiteren Metallschicht 36 beträgt in diesem Ausführungsbeispiel die Hälfte der Dickenerstreckung der Basisschicht 32.

Das Bauelement 40 weist in diesem Ausführungsbeispiel auch einen weiteren elektrischen Anschluss 29 auf, welcher mittels eines Lotmittels 44 mit einem Anschlussschenkel 41 eines Anschlusselements 31 verbunden ist. Das Anschlusselement 31 weist einen Befestigungsfuß 39 auf, welcher einen Schenkel des Anschlusselements 31 bildet. Der Befestigungsfuß 39 und der Anschlussschenkel 41 des Anschlusselements 31 erstrecken sich jeweils in einem rechten Winkel zueinander.

Das Anschlusselement 31 umfasst in diesem Ausführungsbeispiel eine Metallschicht als Basisschicht 33, welche stoffschlüssig, in diesem Ausführungsbeispiel mittels Walzplattieren, mit einer weiteren Metallschicht 35 verbunden ist. Die Metallschichten 33 und 35 liegen in diesem Ausführungsbeispiel unmittelbar aufeinander. Die weitere Metallschicht 35 weist in diesem Ausführungsbeispiel eine größere thermische Leitfähigkeit als die Basisschicht 33. Die weitere Metallschicht 35 ist in diesem Ausführungsbeispiel mit einer weiteren Metallschicht 37 stoffschlüssig verbunden. Die Metallschichten 33 und 37 schließen die weitere Metallschicht 35 - nach Art eines Sandwiches - zwischen einander ein.

Bei dem Anschlusselement 30 schließen die Metallschichten 32 und 36 die weitere Metallschicht 34 - nach Art eines Sandwiches - zwischen einander ein. Die weitere Metallschicht 35 ist in diesem Ausführungsbeispiel als Kupferschicht ausgebildet. Die Basisschicht 33 und die weitere Metallschicht 37 sind in diesem Ausführungsbeispiel durch eine Eisenlegierung, umfassend 42 Prozent Nickel, gebildet.

Das Anschlusselement 30 kann anstelle des Anschlusselements 8 in Fig. 1 mit dem elektronischen Bauteil 3, und dort mit dem elektrischen Anschluss 5, lötverbunden sein. Das Anschlusselement 31 kann anstelle des Anschlusselements 9 in Figur 1 mit dem elektronischen Bauteil 3, und dort mit dem elektrischen Anschluss 4, lötverbunden sein. Das elektronische Bauteil 3 kann somit anstelle der Anschlusselemente 8 und 9 die Anschlusselemente 30 beziehungsweise 31 aufweisen.

Die jeweils einen Befestigungsfuß bildenden Schenkel der Anschlusselemente 30 und 31 weisen in diesem Ausführungsbeispiel voneinander ab. In einer anderen Ausführungsform können die durch die Befestigungsfüße 38 und 39 gebildeten Schenkel aufeinander zuweisen. In dieser Ausführungsform erstrecken sich die Befestigungsfüße 38 und 39 jeweils parallel zu dem elektronischen Bauteil 27, sodass im Fall einer Verbindungsanordnung, wie die Verbindungsanordnung 1, die Befestigungsfüße 38 und 39 zwischen dem elektronischen Bauteil 27 und dem Schaltungsträger 22 angeordnet sind.

## Patentansprüche

1. Elektronisches Bauelement (2, 40), umfassend ein elektrisches Bauteil (3, 27) mit zwei elektrischen Anschlüssen (4, 5, 28, 29), welche jeweils an zueinander gegenüberliegenden Flächen des Bauteils (3, 27) ausgebildet sind, wobei das Bauelement (2, 40) für jeden der Anschlüsse (4, 5, 28, 29) ein elektrisch leitfähiges Anschlusselement (8, 9, 30, 31) aufweist, wobei das Anschlusselement einen Befestigungsfuß (14, 15, 38, 39) zum stoffschlüssigen elektrischen Verbinden, insbesondere Lötverbinden mit einem Schaltungsträger (22) aufweist, wobei das Anschlusselement (8, 9, 30, 31) mit dem elektrischen Anschluss (4, 5, 28, 29) stoffschlüssig verbunden und ausgebildet ist, das Bauelement (2, 40) zu tragen, wobei das Anschlusselement (8, 9, 30, 31) wenigstens zwei miteinander stoffschlüssig verbundene Metallschichten (10, 12, 11, 13, 32, 33, 34, 35, 36, 37), jeweils gebildet aus zueinander verschiedenen Metallen aufweist, wobei eine Basisschicht (10, 11, 32, 33) der Metallschichten mit dem elektrischen Anschluss (4, 5, 28, 29) verbunden ist und im Bereich des Befestigungsfußes (14, 15, 38, 39) zum Lötverbinden mit einem Schaltungsträger (22) ausgebildet ist, so dass die wenigstens eine weitere Metallschicht (12, 13, 34, 35) der Metallschichten zu der Basisschicht (10, 11, 32, 33) thermisch parallel geschaltet ist, wobei die weitere Metallschicht (12, 13, 34, 35) eine größere thermische Leitfähigkeit aufweist als die Basisschicht (10, 11, 32, 33)
**dadurch gekennzeichnet, dass**
das Anschlusselement (8, 9, 30, 31) eine weitere Metallschicht (36, 37) aufweist, welche aus dem Metall der Basisschicht (10, 11, 32, 33) gebildet ist, wobei die Metallschicht mit der größeren thermischen Leitfähigkeit zwischen der Basisschicht (10, 11, 32, 33) und der weiteren Metallschicht (36, 37) aus dem Metall der Basisschicht (10, 11, 32, 33) - insbesondere nach Art eines Sandwiches - eingeschlossen ist.

2. Bauelement (2, 40) nach Anspruch 1,
**dadurch gekennzeichnet, dass**
die Metallschichten (10, 11, 12, 13, 32, 33, 34, 35, 36, 37) mindestens von der Verbindung zum Anschluss (4, 5, 28, 29) des Bauelements (2, 40) bis hin zum Befestigungsfuß (14, 15, 38, 39) stoffschlüssig miteinander verbunden sind.

3. Bauelement (2, 40) nach einem der vorhergehenden Ansprüche,
**dadurch gekennzeichnet, dass**
die Basisschicht (10, 11, 32, 33) durch eine Legierung umfassend Eisen gebildet ist und die weitere Metallschicht (12, 13, 34, 35) mit der größeren thermischen Leitfähigkeit als die Basisschicht (12, 13, 34, 35) durch eine Kupferschicht oder Aluminiumschicht gebildet ist.

4. Bauelement (2, 40) nach Anspruch 1 oder 2,
**dadurch gekennzeichnet, dass**
die Basisschicht (10, 11, 32, 33) zwischen 30 und 45 Prozent Nickel und als weiteren Bestandteil Eisen und aufweist.

5. Bauelement (2, 40) nach einem der vorhergehenden Ansprüche,
**dadurch gekennzeichnet, dass**
eine Schichtdicke der mit der Basisschicht (10, 11, 32, 33) verbundenen weiteren Metallschicht (12, 13, 34, 35) zwischen einem Zehntel und der Hälfte der Schichtdicke der Basisschicht (10, 11, 32, 33) beträgt.

6. Bauelement (2, 40) nach einem der vorhergehenden Ansprüche,
**dadurch gekennzeichnet, dass**
das Anschlusselement (8, 9, 30, 31) ein Winkelelement ist, welches zwei aneinander angeformte und sich in einem vorbestimmten Winkel zueinander erstreckende Schenkel (14, 18, 15, 19, 38, 39, 41, 42) aufweist, wobei ein Schenkel den Befestigungsfuß (14, 15, 38, 39) bildet, und der weitere Schenkel (18, 19, 41, 42) einen Anschlussschenkel bildet, welcher mit dem elektrischen Anschluss (4, 5, 28, 29) verbunden ist.

7. Bauelement (2, 40) nach einem der vorhergehenden Ansprüche,
**dadurch gekennzeichnet, dass**
die stoffschlüssig miteinander verbundenen Metallschichten (10, 12, 11, 13, 32, 33, 34, 35, 36, 37) mittels Walzplattieren miteinander verbunden sind.

8. Bauelement (2, 40) nach einem der vorhergehenden Ansprüche,
**dadurch gekennzeichnet, dass**
das Bauteil (3, 27) ein Kondensator, insbesondere keramischer Kondensator ist.

9. Bauelement (2, 40) nach einem der vorhergehenden Ansprüche,
**dadurch gekennzeichnet, dass**
das Bauteil (3, 27) eine Halbleiterdiode oder ein Widerstand ist.

## Claims

1. Electronic component (2, 40), comprising an electrical structural part (3, 27) having two electrical connections (4, 5, 28, 29) formed respectively on mutually opposite surfaces of the structural part (3, 27), wherein the component (2, 40) has an electrically conductive connection element (8, 9, 30, 31) for each of the connections (4, 5, 28, 29), wherein the connection element has a securing foot (14, 15, 38, 39) for cohesive electrical connection, in particular soldering connection, to a circuit carrier (22), wherein the connection element (8, 9, 30, 31) is cohesively connected to the electrical connection (4, 5, 28, 29) and is configured to carry the component (2, 40),
wherein the connection element (8, 9, 30, 31) has at least two metal layers (10, 12, 11, 13, 32, 33, 34, 35, 36, 37) cohesively connected to one another, respectively formed from mutually different metals, wherein a base layer (10, 11, 32, 33) of the metal layers is connected to the electrical connection (4, 5, 28, 29) and in the region of the securing foot (14, 15, 38, 39) is configured for soldering connection to a circuit carrier (22), such that the at least one further metal layer (12, 13, 34, 35) of the metal layers is thermally connected in parallel with the base layer (10, 11, 32, 33), wherein the further metal layer (12, 13, 34, 35) has a greater thermal conductivity than the base layer (10, 11, 32, 33),
**characterized in that**
the connection element (8, 9, 30, 31) has a further metal layer (36, 37), which is formed from the metal of the base layer (10, 11, 32, 33), wherein the metal layer having the greater thermal conductivity is enclosed - in particular in the manner of a sandwich - between the base layer (10, 11, 32, 33) and the further metal layer (36, 37) composed of the metal of the base layer (10, 11, 32, 33).

2. Component (2, 40) according to Claim 1,
**characterized in that**
the metal layers (10, 11, 12, 13, 32, 33, 34, 35, 36, 37) are cohesively connected to one another at least from the link to the connection (4, 5, 28, 29) of the component (2, 40) through to the securing foot (14, 15, 38, 39).

3. Component (2, 40) according to either of the preceding claims,
**characterized in that**
the base layer (10, 11, 32, 33) is formed by an alloy comprising iron, and the further metal layer (12, 13, 34, 35) having the greater thermal conductivity than the base layer (12, 13, 34, 35) is formed by a copper layer or aluminum layer.

4. Component (2, 40) according to Claim 1 or 2,
**characterized in that**
the base layer (10, 11, 32, 33) comprises between 30 and 45 percent nickel and as further constituent iron and.

5. Component (2, 40) according to any of the preceding claims,
**characterized in that**
a layer thickness of the further metal layer (12, 13, 34, 35) connected to the base layer (10, 11, 32, 33) is between one tenth and half of the layer thickness of the base layer (10, 11, 32, 33).

6. Component (2, 40) according to any of the preceding claims,
**characterized in that**
the connection element (8, 9, 30, 31) is an angular element having two limbs (14, 18, 15, 19, 38, 39, 41, 42) integrally formed on one another and extending at a predetermined angle with respect to one another, wherein one limb forms the securing foot (14, 15, 38, 39) and the further limb (18, 19, 41, 42) forms a connection limb, which is connected to the electrical connection (4, 5, 28, 29).

7. Component (2, 40) according to any of the preceding claims,
**characterized in that**
the metal layers (10, 12, 11, 13, 32, 33, 34, 35, 36, 37) cohesively connected to one another are connected to one another by means of roll bonding.

8. Component (2, 40) according to any of the preceding claims,
**characterized in that**
the structural part (3, 27) is a capacitor, in particular a ceramic capacitor.

9. Component (2, 40) according to any of the preceding claims,
**characterized in that**
the structural part (3, 27) is a semiconductor diode or a resistor.

## Revendications

1. Module électronique (2, 40) comprenant un composant électrique (3, 27) doté de deux bornes (4, 5, 28, 29) de raccordement électrique formées sur des surfaces mutuellement opposées du composant (3, 27), le module (2, 40) présentant un élément électriquement conducteur de raccordement (8, 9, 30, 31) pour chacune des bornes de raccordement (4, 5, 28, 29), l'élément de raccordement présentant un pied de fixation (14, 15, 38, 39) permettant une liaison électrique en correspondance de matière, en particulier une liaison brasée, avec un porte-circuit (22), l'élément de raccordement (8, 9, 30, 31) étant relié en correspondance de matière avec la borne électrique (4, 5, 28, 29) et étant configuré pour porter le module (2, 40),
l'élément de raccordement (8, 9, 30, 31) présentant au moins deux couches métalliques (10, 12, 11, 13, 32, 33, 34, 35, 36, 37) reliées l'une à l'autre en correspondance de matière, chacune formée de métaux différents les uns des autres, une couche de base (10, 11, 32, 33) des couches métalliques étant reliée à la borne de raccordement (4, 5, 28, 29) et étant configurée au niveau du pied de fixation (14, 15, 38, 39) pour une liaison brasée avec un porte-circuit (22) de telle sorte que la ou les autres couches métalliques (12, 13, 34, 35) soient raccordées thermiquement en parallèle à la couche de base (10, 11, 32, 33), l'autre couche métallique (12, 13, 34, 35) présentant une conductivité thermique plus grande que la couche de base (10, 11, 32, 33),
**caractérisé en ce que**
l'élément de raccordement (8, 9, 30, 31) présente une autre couche métallique (36, 37) formée du métal de la couche de base de la couche de base (10, 11, 32, 33), la couche métallique présentant la plus grande conductivité thermique étant incorporée, en particulier en sandwich, entre la couche de base (10, 11, 32, 33) et l'autre couche métallique (36, 37) en le métal de la couche de base (10, 11, 32, 33).

2. Module (2, 40) selon la revendication 1, **caractérisé en ce que** les couches métalliques (10, 11, 12, 13, 32, 33, 34, 35, 36, 37) sont reliées en correspondance de matière les unes aux autres au moins depuis la liaison à la borne (4, 5, 28, 29) du module (2, 40) jusqu'au pied de fixation (14, 15, 38, 39).

3. Module (2, 40) selon l'une des revendications précédentes, **caractérisé en ce que** la couche de base (10, 11, 32, 33) est formée d'un alliage contenant du fer et **en ce que** l'autre couche métallique (12, 13, 34, 35) dont la conductivité thermique est plus grande que celle de la couche de base (12, 13, 34, 35) est formée d'une couche de cuivre ou d'une couche d'aluminium.

4. Module (2, 40) selon les revendications 1 ou 2, **caractérisé en ce que** la couche de base (10, 11, 32, 33) présente entre 30 et 45 pourcent de nickel et comme autre composant, le fer et.

5. Module (2, 40) selon l'une des revendications précédentes, **caractérisé en ce que** l'autre couche métallique (12, 13, 34, 35) reliée à la couche de base (10, 11, 32, 33) présente entre un dixième et la moitié de l'épaisseur de la couche de base (10, 11, 32, 33).

6. Module (2, 40) selon l'une des revendications précédentes, **caractérisé en ce que** l'élément de raccordement (8, 9, 30, 31) est un élément coudé qui présente deux branches (14, 18, 15, 19, 38, 39, 41, 42) formées l'une sur l'autre et formant l'une par rapport à l'autre un angle prédéterminé, une branche formant le pied de fixation (14, 15, 38, 39) et l'autre branche (18, 19, 41, 42) formant une branche de raccordement reliée à la borne électrique (4, 5, 28, 29).

7. Module (2, 40) selon l'une des revendications précédentes, **caractérisé en ce que** les couches métalliques (10, 12, 11, 13, 32, 33, 34, 35, 36, 37) reliées les unes aux autres en correspondance de matière sont reliées les unes aux autres au moyen d'un placage laminé.

8. Module (2, 40) selon l'une des revendications précédentes, **caractérisé en ce que** le composant (3, 27) est un condensateur et en particulier un condensateur céramique.

9. Module (2, 40) selon l'une des revendications précédentes, **caractérisé en ce que** le composant (3, 27) est une diode semi-conductrice ou une résistance.
